(19) Europäisches Patentamt
European Patent Office
Office européen des brevets

(11) EP 1 545 006 A1

(12) **EUROPEAN PATENT APPLICATION**

(43) Date of publication:
**22.06.2005 Bulletin 2005/25**

(51) Int Cl.[7]: **H03L 7/081**, H03D 3/00, H03B 27/00

(21) Application number: **03447297.7**

(22) Date of filing: **19.12.2003**

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(71) Applicants:
- **Interuniversitair Microelektronica Centrum vzw ( IMEC)
3001 Leuven (BE)**
- **STMicroelectronics Belgium N.V.
1930 Zaventem (BE)**

(72) Inventor: **Craninckx, Jan Frans Lucien
3370 Boutersem (BE)**

(74) Representative: **Van Malderen, Joelle et al
pronovem - Office Van Malderen
Avenue Josse Goffin 158
1082 Bruxelles (BE)**

(54) **Local oscillator for harmonic image-rejection mixers**

(57) The present invention is related to a device for generating signals spaced π/X rad apart (X being an integer) comprising

- at least one delay cell (15) with a delay approximately corresponding to a phase shift π/X rad, and
- at least one phase detection system (16) inputting at least two signals (10) delayed by the delay cell (s) (15) and generating a feedback signal (18) to at least one delay cell (15).

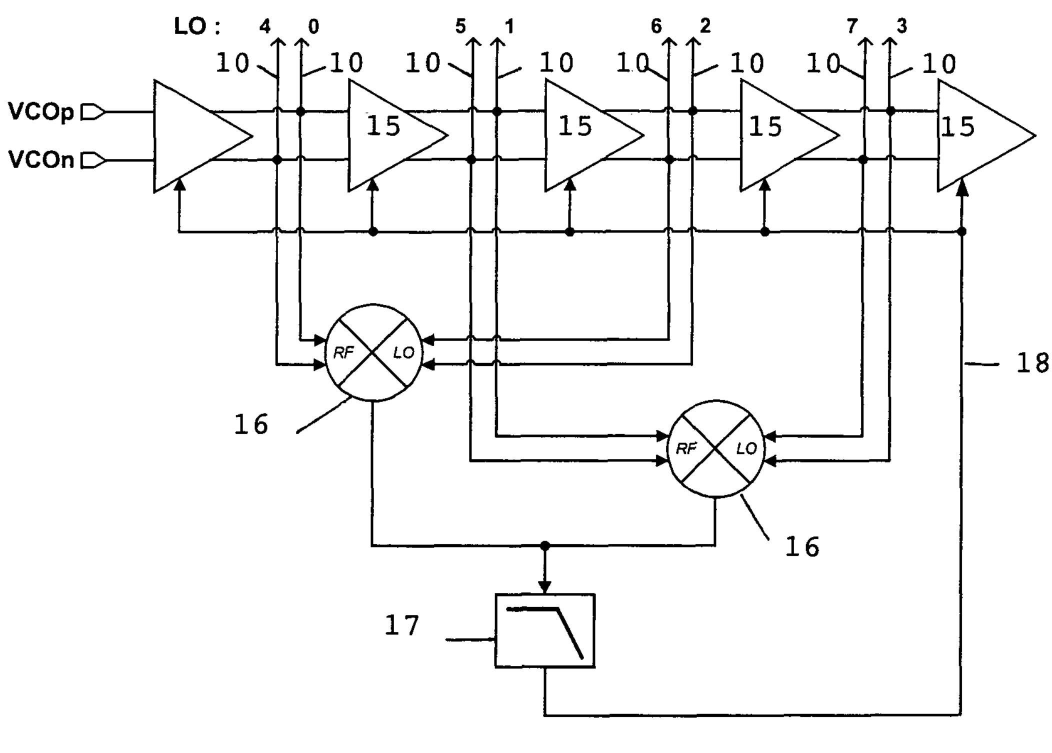


Fig.7

EP 1 545 006 A1

## Description

### Field of the invention

The present invention is related to a device that generates signals to be used for frequency conversion in image-reject mixers.

### State of the art

To implement low-cost single-chip RF transceivers current receive and transmit architectures employ zero-IF or low-IF techniques. The image frequency is no longer suppressed by filtering as in the heterodyne architectures. In these architectures image-reject or quadrature up- and downconversion mixers are used. The main problem of these image-rejection transceivers is they rely on a local oscillator (LO) having an in-phase component (I) and a quadrature component (Q) spaced exactly 90° apart. The I and Q LO signals often lead to difficulties in practical implementations.

In state of the art solutions LO signals in quadrature can be generated by a 4-stage ring oscillator. Ring oscillators however produce too much phase noise to be used in most telecom applications. Alternatively, the LO signals (I and Q) generation can be performed starting from a normal VCO signal with an RC/CR circuit. The RC time constant should then equal the input signal period, which is never exactly the case in practice. Further the oscillator runs at the same frequency as the RF output signal, which makes the VCO susceptible to pulling by the power amplifier, causing unwanted spurs in the output signal.

Other solutions consist in applying a quadrature LC-oscillator, coupling two high-quality LC oscillators in such a way that their output signals are 90° apart. These two oscillators however take up a large area and they are also very susceptible to pulling.

Another alternative exists in using an oscillator running at the double frequency of the output signals. One can then obtain signals in quadrature with a simple divide-by-2 toggle flipflop. Running at twice the required operating frequency however, if even possible notwithstanding technological limitations, takes a lot of power. The pulling problem is not completely solved either, since the VCO can be pulled by the second harmonic of the power amplifier.

### Aims of the invention

The present invention aims to provide a device facilitating the generation of an in phase and a quadrature component LO signal, thereby overcoming the problems of the state of the art solutions.

### Summary of the invention

The present invention relates to a device for generating (at least two) signals spaced $\pi/X$ rad apart, X being an integer, comprising

- at least one tunable delay cell with a delay approximately corresponding to a phase shift $\pi/X$ rad,
- at least one phase detection system inputting at least two signals delayed by the delay cells and generating a feedback signal to at least one delay cell.

In a preferred embodiment the combination of the delay cells and the phase detection system provides the $\pi/X$ rad spacing of the signals. In a specific embodiment X equals 4.

Typically the at least two signals input by the phase detecting system are delayed by $\pi/2$ rad with respect to one another.

In an advantageous embodiment the phase detection system is a mixer.

Preferably the device further comprises a filter for filtering the feedback signal.

In a specific embodiment the feedback signal is fed to all delay cells.

The invention also relates to a device for converting at least two signals at a first frequency to a signal at a second frequency comprising

- a device as described above, generating a plurality of signals at the first frequency, which is a subharmonic frequency of the second frequency, and
- first means for combining the at least two signals from the plurality of signals, yielding a first signal set containing at least one signal at the second frequency.

Preferably the at least two signals to be combined by said first means for combining are spaced $2\pi/X$ rad

apart and the second frequency is X/2 times larger than the first frequency. Advantageously X equals 4.

In an even more preferred embodiment the device further comprises a second means for combining the at least two signals at said first frequency from said plurality of signals, yielding a second signal set containing at least one signal at said second frequency. Again, the at least two signals to be combined by the second means for combining are spaced 2π/X rad apart and the second frequency is X/2 times larger than the first frequency. For each of the at least two signals to be combined by the second means for combining there is a signal among the at least two signals to be combined by the first means for combining, that differs π/X rad in phase. This results in said first and second signal set at said second frequency being spaced π/2 apart, which is preferable for the LO signals in image-reject up- or downconverters. Advantageously X is taken equal to 4.

Advantageously the means for combining signals includes a logic circuit or a combination of switches.

As another object the invention relates to a device for frequency multiplication comprising a local oscillator running at a subharmonic frequency of a transceived signal, generating at least one output signal. The device further comprises means for generating signals, spaced π/2N rad apart, N being an integer. The local oscillator runs at the N-th subharmonic of said transceived signal. The at least one output signal is generated by said signals, spaced π/2N rad apart. In a most preferred embodiment N = 2.

In a specific embodiment the device for frequency conversion generates an in-phase and a quadrature output signal.

In a further object the invention relates to a front-end device, comprising a device for frequency conversion as described above and a mixer to which the at least one output signal and said transceived signal are fed.

In yet a further object the invention relates to a zero or low-IF front end, comprising a frequency conversion device as described above and an image-reject mixer to which the in-phase and quadrature output signals and said transceived signal are fed.

In a more advanced embodiment the front end device comprising a frequency conversion device as described above, possesses some programmable parameters. The programmable parameters comprise the integer value N and the number of signals to be generated. The front end device may further comprise reconfigurable means for combining said generated signals.

## Short description of the drawings

Fig. 1 represents a direct upconversion transmitter.

Fig. 2 represents a RC/CR phase shifter.

Fig. 3 represents a harmonic image-rejection upconversion.

Fig. 4 represents a harmonic mixer example.

Fig. 5 represents an embodiment as frequency doubling device.

Fig. 6 represents some harmonic mixer waveforms.

Fig. 7 represents a delay-locked loop for half-frequency 8-phase LO signal generation.

## Detailed description of the invention

A prior art solution is shown in Fig. 1. The figure represents the basic schematic of a direct-upconversion (or zero-IF) transmitter. The baseband signals are defined as :

$$BB_I = cos(\omega_{BB} \cdot t)$$

$$BB_Q = sin(\omega_{BB} \cdot t)$$

The LO signals are defined as:

$$LO_I = COS(\omega_{LO} \cdot t)$$

$$LO_Q = sin(\omega_{LO} \cdot t)$$

The circuit in Figure 1 thus performs the following function :

$$
\begin{aligned}
RF &= BB_I \cdot LO_Q + BB_Q \cdot LO_I \\
&= \cos(\omega_{BB} \cdot t) \times \sin(\omega_{LO} \cdot t) + \sin(\omega_{BB} \cdot t) \times \cos(\omega_{LO} \cdot t) \\
&= \sin\left((\omega_{LO} + \omega_{BB}) \cdot t\right) \\
&= \sin(\omega_{RF} \cdot t)
\end{aligned}
$$

which is a perfect single-sideband mixer. A similar calculation can be performed for the receiver side.

The generation of LO signals in quadrature can also be done starting from a normal VCO signal (IN) with an RC/CR circuit as shown in Fig. 2. If the RC-time constant is equal to the frequency of the input signal, one path shifts the phase by +45° and the other path shifts by -45°, thus rendering two LO signals (OUTi and OUTq) 90° apart. The problems of an RC/CR phase shifter are twofold :

- First, due to process variations the RC time constant never exactly equals the input frequency. This does not influence the phase difference between the two outputs, but it does influence their amplitude. So if the mixers are susceptible to the amplitude of their LO signals, this will give imperfect image rejection. Extensions of the basic RC/CR phase shifter are polyphase networks, which use several sections at different frequencies in order to obtain a good image rejection over a wide band (at the expense of larger area and power).
- Second, the oscillator in the synthesiser is running at the same frequency as the RF output signal. This makes this VCO very susceptible to pulling by the power amplifier in TX mode, thus creating unwanted spurs in the output signal. In RX mode DC offsets are generated by coupling of the VCO signal to the RF input. These DC offsets are a major problem for implementing zero-IF receivers.

To solve both the problem of VCO pulling in transmit mode and DC offsets in receive mode, the VCO will be operated at a sub-harmonic of the RF signal and a harmonic mixer is used. The key element is the generation of LO signals in quadrature at this subharmonic frequency, which shouldn't be spaced $\pi/2$ rad apart, but $\pi/2N$ rad (wherein N denotes the subharmonic order, e.g. 2). A delay-locked loop generates these LO signals. Note that "spaced y rad apart" means the signals have the same frequency, but they have a phase difference of y rad.

The main goal of the proposed solution is to run the oscillator at a subharmonic (e.g. half) of the RF frequency, in order to avoid pulling. In that case the upconversion mixer must be a harmonic mixer. Also, in order to retain an image-rejection upconversion, 45° spaced LO signals are then needed. A possible solution for implementing a harmonic mixer applies a 45° phase shifter consisting of two RC-bridge circuits (see *'An I/Q Active Balanced* Harmonic *Mixer with IM2 Cancelers and a 45° phase Shifter',* IEEE Journal of Solid-State Circuits, vol. 33, no. 12, Dec.1998, pp 2240-2246). In the invention a different approach is followed. In Fig. 3 two signals spaced $2.\pi/4$ rad apart are combined to yield either the I or the Q component at RF frequency : in one case signals with phase 0 and $\pi/2$ are taken together, in the other those with $\pi/4$ and $3\pi/4$. For each of the signals going to one mixer (21), there is a signal that differs $\pi/4$ rad in phase, going to the other mixer (22).

An example of a harmonic upconversion circuit is shown in Fig. 4 (only the 1-mixer is shown). It looks similar to a standard Gilbert-cell mixer, except that the four switch transistors have been replaced by a new switch structure. The LO signals (10) have an index, which is proportional to their phase in units of 45°, so $LO_i = \cos(\omega_{LO} \cdot t + i \cdot 45°)$ with i=0, 1,..., 7. The waveforms of the LO signals (10) and their corresponding equivalent signal in the mixer are shown in Fig. 6. This circuit is equivalent to putting an XOR gate on the half-frequency LO signals (as shown in Fig. 5) before feeding them into a regular mixer. A similar circuit can be used for downconversion.

To create the 8 half-frequency LO signals (10) at 45° spacing, the circuit of Fig. 7 can be used. It consists of a series of voltage-controlled delay cells (15), the delay of which is tuned to 45° by a feedback loop similar to a PLL. Four delay cells with a delay approximately corresponding to $\pi/4$ rad are needed in this case. The mixers operate as phase detectors (16), but due to the implementation as Gilbert cells, their output is zero when the 'RF' and 'LO' signals are spaced 90° apart. To avoid deterministic phase mismatch, the phase detectors should be implemented symmetrically w.r.t. their RF and LO inputs. This basically means that preferably two mixers (21,22) of half the size must be used, with their inputs swapped.

As for phase noise on the 8-phase LO signals, this is determined almost completely by the oscillator signals. The delay cells (15) must be implemented such that their noise is negligible, and if the loop bandwidth is sufficiently small, this only contributes to close-by phase noise.

In a specific embodiment the invention relates to a frequency multiplication device. Fig.5 shows a device that converts the original LO signals to new LO signals at the actual RF frequency. The LO signals (10) shown in Fig. 7 are the inputs. The phase detector (16) in Fig. 7 can also be used with the signals of L02.

It is evident that a similar circuit can be described operating on a frequency $\omega_{LO}$ equal to $1/3^{rd}$ of the RF

frequency, requiring 12 LO signals (10) spaced 2π/12 rad = 30° apart. In this case LO signals (10) are generated $LO_i = cos(\omega_{LO} \cdot t + i \cdot 30°)$ , with i = 0,1,...,11 (or i = 0,1,...,5 in case no symmetrical implementation is chosen). Three signals must then be taken together that are 2.(2π/12)= π/3 rad apart, like for example those with phases 0, π/3 and 2π/3 rad together or those with phases π/6, π/2 and 5π/6 rad. The combination of these LO signals can then be fed into the harmonic mixer.

The invention also relates to a device for frequency conversion from RF to IF (or vice versa), comprising a LO running at a subharmonic of the amount of frequency translation (= $F_{RF}$-$F_{IF}$) with $F_{IF} \neq 0$ (as opposed to what was previously discussed). The device further comprises means for generating signals derived from this local oscillator signal, spaced π/2N rad apart, N being an integer. The output signal (e.g. IF) is generated by mixing the input signal (e.g. RF) with said LO signals, spaced π/2N rad apart. By further adding a second mixer with the other LO signals, one obtains a full image-reject mixer.

Some of the above-mentioned parameters can be rendered programmable, like e.g. the number of signals to be generated, the integer value N indicating at which subharmonic frequency the local oscillator runs etc. Also the means for combining signals (e.g. the logic circuit) may be reconfigurable. Such small changes may have a considerable impact on the front end's functionality.

The solution of the invention offers several advantages:

- The pulling problem is completely solved, as the VCO is running at half of the RF frequency.
- Instead of routing 4 quadrature LO signals from the synthesiser to the RX and TX sections, now only 2 half frequency signals must be distributed across the chip. The LO-generating DLL can be placed twice, once close to the RX mixer and once close to the TX mixer. For area efficiency, the two loops can possibly share their lowfrequency part.
- The above routing advantage also results in a reduction of the power consumption in the LO buffers.
- It allows to implement a frequency conversion device that is to a certain extent programmable.

## Claims

**1.** Device for generating signals (10) spaced π/X rad apart, X being an integer, comprising

- at least one delay cell (15) with a delay approximately corresponding to a phase shift π/X rad,
- at least one phase detection system (16) inputting at least two signals (10) delayed by said delay cells (15) and generating a feedback signal (18) to at least one delay cell (15).

**2.** Device as in claim 1, wherein the combination of said delay cells (15) and said phase detection system (16) provides said π/X rad spacing of said signals (10).

**3.** Device as in claim 1, wherein said at least two signals (10) input by said phase detecting system (16) are delayed by π/2 rad with respect to one another.

**4.** Device as in claim 1, wherein said phase detection system (16) is a mixer.

**5.** Device as in claim 1, further comprising a filter (17) for filtering said feedback signal (18).

**6.** Device as in claim 5, wherein said feedback signal (18) is fed to all delay cells (15).

**7.** Device for converting at least two signals (10) at a first frequency to a signal at a second frequency comprising

- a device as in claim 1, generating a plurality of signals (10) at said first frequency, said first frequency being a subharmonic frequency of said second frequency and
- first means (12) for combining said at least two signals (10) from said plurality of signals, yielding a first signal set containing at least one signal at said second frequency.

**8.** Device as in claim 7, **characterised in that** said at least two signals (10) to be combined by said first means (12) for combining are spaced 2π/X rad apart and **in that** said second frequency is X/2 times larger than said first frequency.

**9.** Device as in claim 8, **characterised in that** X equals 4.

**10.** Device as in claim 8, **characterised in that** it further comprises a second means for combining said at least two signals (10) from said plurality of signals, yielding a second signal set containing at least one signal at said second frequency.

**11.** Device as in claim 10, **characterised in that** said at least two signals (10) to be combined by said second means for combining are spaced $2\pi/X$ rad apart and **in that** for each of said at least two signals to be combined by said second means for combining there is a signal among said at least two signals to be combined by said first means for combining, that differs $\pi/X$ rad in phase.

**12.** Device as in claim 11, **characterised in that** X equals 4.

**13.** Device as in claim 7, wherein said means for combining signals includes a logic circuit.

**14.** Device as in claim 7, wherein said means for combining signals includes a combination of switches.

**15.** A device for frequency multiplication comprising a local oscillator running at a subharmonic frequency of a transceived signal, generating at least one output signal, **characterised in that** said device further comprises means for generating signals, spaced $\pi/2N$ rad apart, N being an integer, **in that** said local oscillator runs at the N-th subharmonic of said transceived signal and **in that** said at least one output signal is generated by said signals, spaced $\pi/2N$ rad apart.

**16.** A device as in claim 15, generating an in-phase and a quadrature output signal.

**17.** A front-end device, comprising a device as in claim 15 and a mixer (21) to which said at least one output signal and said transceived signal are fed.

**18.** A zero or low-IF front end, comprising a device as in claim 16 and a mixer (21) to which said output signals and said transceived signal are fed.

**19.** A front end device with programmable parameters, comprising a device as in claim 15.

**20.** A front end device as in claim 19, wherein said programmable parameters comprise the integer value N and the number of signals to be generated, said front end device further comprising reconfigurable means for combining said generated signals.

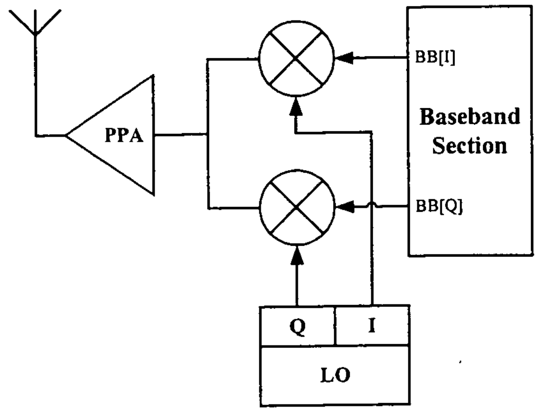


Prior art

Fig.1

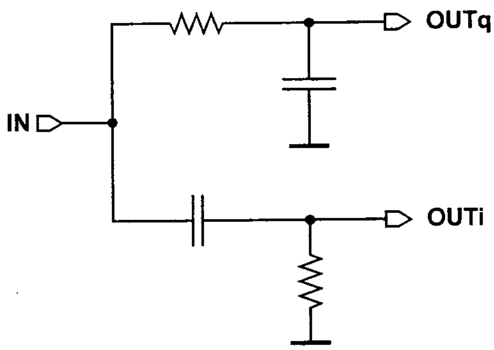


Prior art

Fig.2

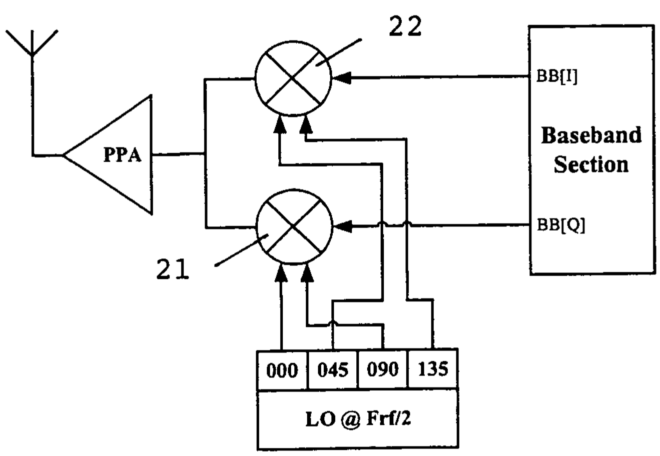


Fig.3

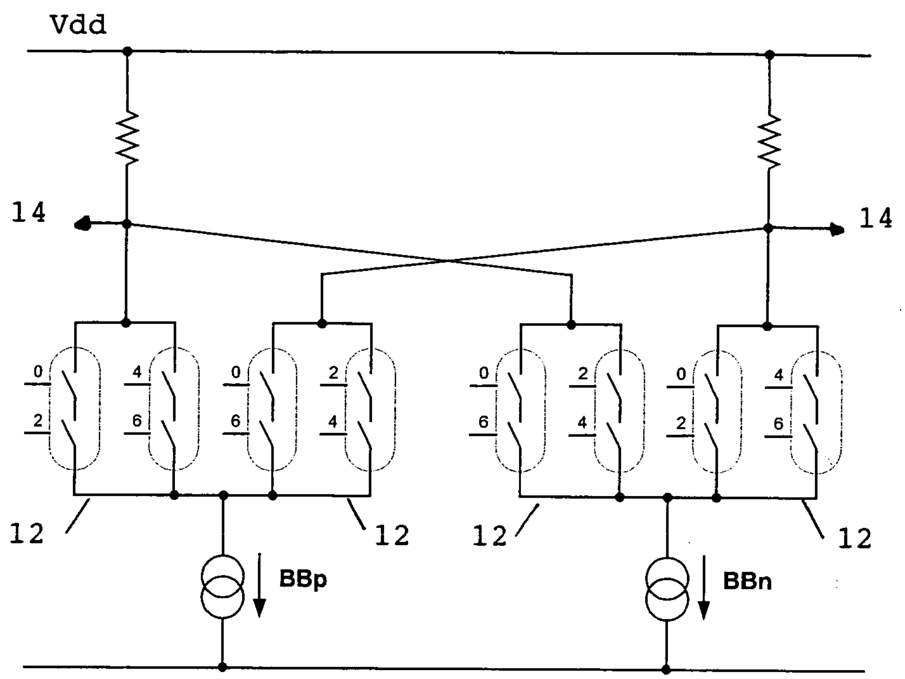
Vdd
14
14
0
2
4
6
0
6
2
4
0
6
2
4
0
2
4
6
12
12
12
12
BBp
BBn

Fig.4

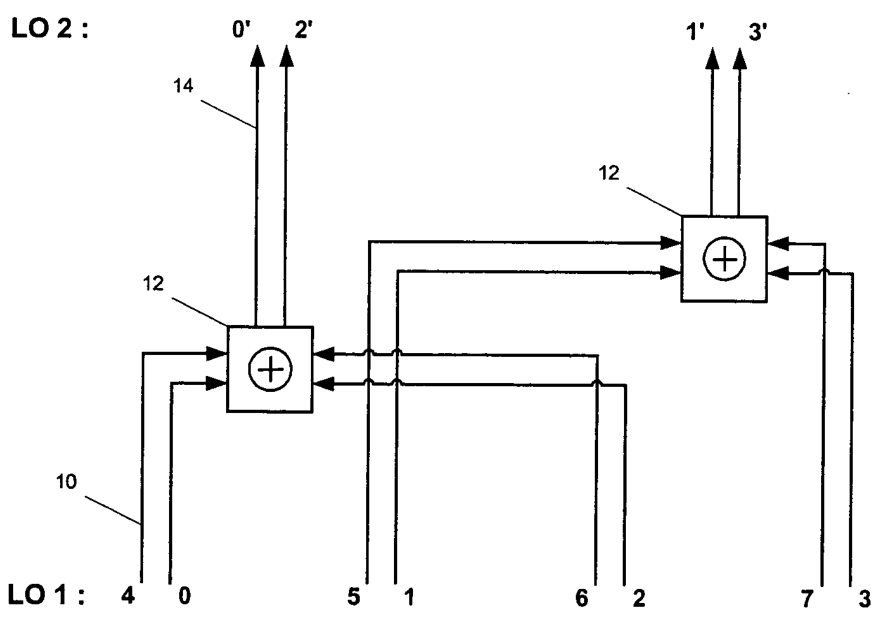
LO 2 :
0'
2'
1'
3'
14
12
12
10
LO 1 :
4
0
5
1
6
2
7
3

Fig.5

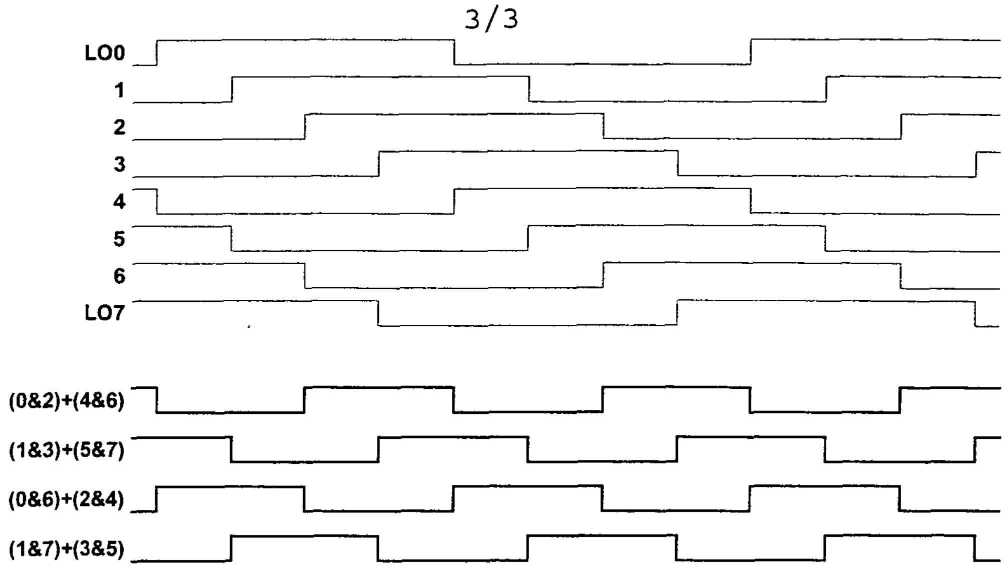
LO0
1
2
3
4
5
6
LO7
(0&2)+(4&6)
(1&3)+(5&7)
(0&6)+(2&4)
(1&7)+(3&5)

Fig.6

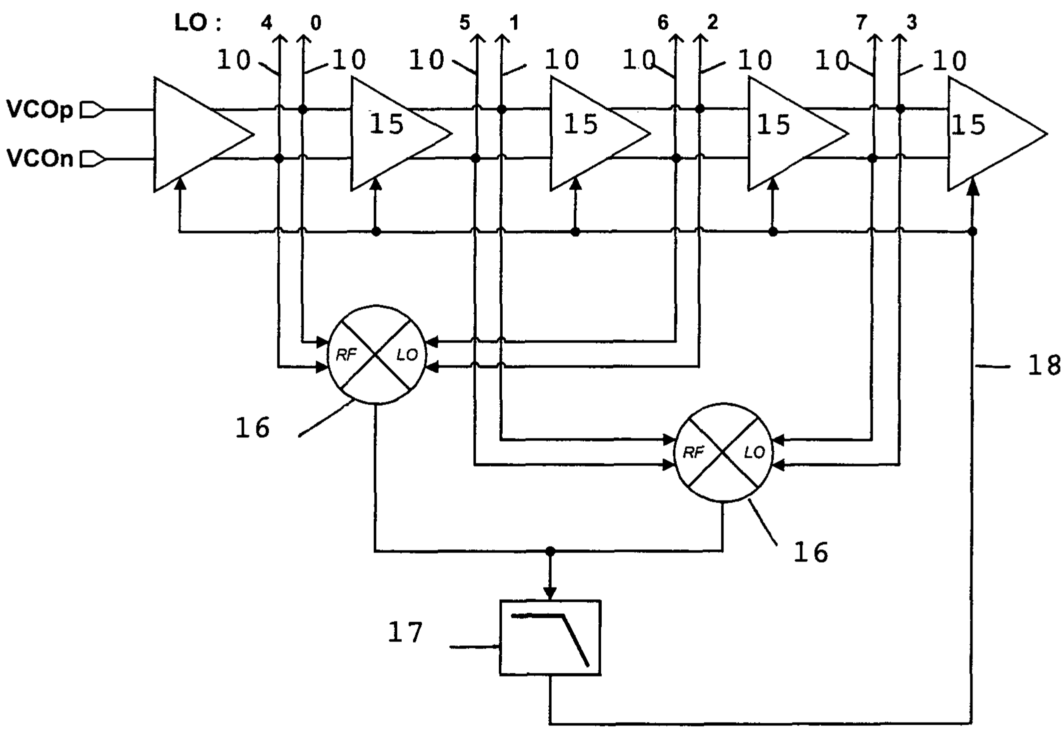
LO :
4
0
5
1
6
2
7
3
10
VCOp
VCOn
15
RF
LO
16
17
18

Fig.7

European Patent Office

# EUROPEAN SEARCH REPORT

Application Number
EP 03 44 7297

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X<br><br>Y | US 5 146 121 A (SEARLES SHAWN ET AL)<br>8 September 1992 (1992-09-08)<br>* abstract; figure 1 *<br>--- | 1,2,4-6<br><br>3,7-14 | H03L7/081<br>H03D3/00<br>H03B27/00 |
| Y | US 5 285 120 A (LANDT HARVEY L)<br>8 February 1994 (1994-02-08)<br>* column 2, line 10 - line 26; figure 1 *<br>--- | 3 | |
| Y | EP 0 261 451 A (SIEMENS AG)<br>30 March 1988 (1988-03-30)<br>* the whole document *<br>--- | 7-14 | |
| X,D | YAMAJI T ET AL: "I/Q ACTIVE BALANCED HARMONIC MIXER WITH IM2 CANCELERS AND A 45° PHASE SHIFTER"<br>IEEE JOURNAL OF SOLID-STATE CIRCUITS, IEEE INC. NEW YORK, US,<br>vol. 33, no. 12, December 1998 (1998-12), pages 2240-2246, XP000880529<br>ISSN: 0018-9200<br>* page 2243, column 2, line 20 - page 2244, column 1, line 5; figure 12 *<br>----- | 15-18 | TECHNICAL FIELDS SEARCHED (Int.Cl.7)<br>H03L<br>H03D<br>H03B |

The present search report has been drawn up for all claims

3

| Place of search | Date of completion of the search | Examiner |
|---|---|---|
| MUNICH | 26 May 2004 | Boudet, J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO. EP 03 44 7297

This annex lists the patent family members relating to the patent documents cited in the above-mentioned European search report.
The members are as contained in the European Patent Office EDP file on
The European Patent Office is in no way liable for these particulars which are merely given for the purpose of information.

26-05-2004

| Patent document cited in search report | | Publication date | Patent family member(s) | | Publication date |
|---|---|---|---|---|---|
| US 5146121 | A | 08-09-1992 | CA | 2073888 A1 | 25-04-1993 |
| | | | US | 5179303 A | 12-01-1993 |
| US 5285120 | A | 08-02-1994 | NONE | | |
| EP 0261451 | A | 30-03-1988 | EP | 0261451 A1 | 30-03-1988 |
| | | | JP | 63065313 A | 23-03-1988 |
| | | | US | 4737721 A | 12-04-1988 |

EPO FORM P0459

For more details about this annex : see Official Journal of the European Patent Office, No. 12/82